# EUROPÄISCHE PATENTANMELDUNG

(11) **EP 0 905 700 A2**
(43) Veröffentlichungstag der Anmeldung: **31.03.1999**
(21) Anmeldenummer: 98115826.4
(22) Anmeldetag: 21.08.1998
(51) Int. Cl.: G11C 5/00

(54) **Platine für Datenverarbeitungsgerät**

(30) Priorität: 24.09.1997 DE 19742131
(71) Anmelder: SIEMENS AKTIENGESELLSCHAFT, 80333 München (DE)
(72) Erfinder: Hofmeister, Klaus, 80337 München (DE)

(57) **Zusammenfassung**

Eine Platine, zum Beispiel für ein Datenverarbeitungsgerät, weist eine Mehrzahl von Speicherbausteinen (RAM) auf, die mittels nicht lösbarer Verbindungen (C) mit der Platine (P) verbunden sind.

## Beschreibung

Die vorliegende Erfindung betrifft eine Platine nach dem Oberbegriff des Patentanspruches 1, insbesondere eine solche für ein Datenverarbeitungsgerät wie zum Beispiel einen Personalcomputer.

Gattungsgemäße Platinen weisen bekanntlich einen oder mehrere Prozessorbausteine auf, sowie weitere elektronische Bauelemente, die der Funktion des Prozessorbausteins dienen sowie seiner Kommunikation mit peripheren Geräten wie zum Beispiel Festplatte, Diskettenlaufwerk, Drucker, usw. Speicherbausteine für Arbeitsspeicher sind über auf der Platine vorgesehene Steck- oder Klemmleisten mit dem Prozessor (zumindest mittelbar) verbindbar. Beispielsweise Personalcomputer (und somit deren Prozessor auf einer gattungsgemäßen Platine) sind bekanntlich mit Arbeitsspeichern ausgestattet, deren Größe (in einem vorgegebenen Raster) individuell bestimmbar ist. Entsprechend der gewählten Größe des Arbeitsspeichers eines Personalcomputers wird bei seiner Herstellung demzufolge eine von Personalcomputer zu Personalcomputer verschiedene Anzahl von sogenannten SIMM- bzw. DIMM-Modulen, die die Speicherbausteine des künftigen Arbeitsspeichers enthalten, auf die sogenannte Prozessorplatine (englisch: Mother Board) gesteckt. Jede solche Platine wird also bei der Herstellung des Personalcomputers individuell, in Abhängigkeit von der gewünschten Größe des Arbeitsspeichers, mit der entsprechenden Anzahl von Modulen bestückt. In der Praxis hat sich nun erwiesen, daß der Großteil der Käufer von Personalcomputern sich standardmäßig mit einer bestimmten Größe des Arbeitsspeichers 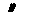 zufrieden" gibt, zum Beispiel 16 MByte bzw. neuerdings 32 MByte. Dies ist in der Regel vollkommen ausreichend bei Verwendung von sogenannter Standard-Software, zum Beispiel Verwendung eines der sogenannten Office-Pakete. Da jedoch die Prozessorplatinen nach wie vor individuell entsprechend den Kundenanforderungen mit den Arbeitsspeicherbausteinen in einer Anzahl entsprechend der gewünschten Größe des Arbeitsspeichers bestückt werden (zum Beispiel mittels der vorgenannten SIMM-Module), ist dies sowohl von dem dafür notwendigen Arbeitsaufwand wie auch dem Zeitaufwand sehr kostenträchtig.

Einen Überblick über den Einsatz gehäuseloser ICs gibt der Artikel von E. Ziegler in ELEKTRONIK PRODUKTION & PRÜFTECHNIK, November 1983, S. 728 bis 730.

In Humbert, H.-J., 64'er-Hardware-Buch, Haar bei München, Markt & Technik Verlag, 1992, Seiten 52, 53 und 118 bis 121 wird die Anordnung von Speicherbausteinen auf der Platine eines Rechners beschrieben.

Aufgabe der vorliegenden Erfindung ist es, eine Platine zu schaffen, die billiger herstellbar ist.

Diese Aufgabe wird bei einer gattungsgemäßen Platine gelöst mit den kennzeichnenden Merkmalen des Patentanspruches 1. Vorteilhafte Aus- und Weiterbildungen sind in Unteransprüchen gekennzeichnet.

Der Vorteil dieser Erfindung liegt nicht nur darin, die Platine billiger produzieren zu können, da sie nur einen "Standard"-Fertigungsprozeß benötigt, sondern auch darin, daß sich Signallaufzeiten, die bei der heutigen Diskrepanz zwischen Prozessorgeschwindigkeit (derzeit typischer Wert: 200 MHz) und Geschwindigkeit der Speicherbausteine (max. 66 MHz) als zusätzliches Hemmnis bezüglich der Geschwindigkeit des Gesamtsystems Rechner auftreten, verkürzt werden und die somit das Geschwindigkeitsverhalten des Rechners insgesamt positiv beeinflussen.

Die Erfindung wird nachstehend anhand der Zeichnung näher erläutert. Es zeigen:
- Figuren 1, 2 und 5: verschiedene Ausführungsformen der Erfindung,
- Figuren 3 und 4: Details der Erfindung.

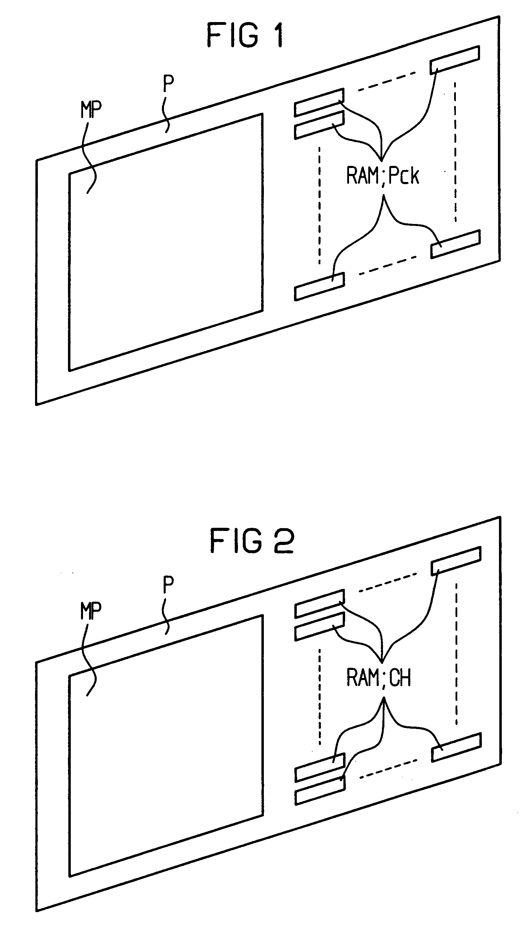

Figur 1 zeigt symbolisch eine Platine P mit einem Mikroprozessorbaustein MP und einer Anzahl von Speicherbausteinen RAM. Die Speicherbausteine RAM sind dabei solche, deren Chips in Gehäuse (Pck) montiert sind. Die Speicherbausteine RAM sind mittels nicht lösbarer Verbindungen C auf der Platine P montiert. Unter einer nicht lösbaren Verbindung C wird dabei eine Verbindung verstanden, die ohne eine chemische oder physikalische Veränderung (zum Beispiel Entlöten einer Lötverbindung durch Erhitzen des Lotes bis zur Schmelztemperatur) nicht aufhebbar ist. Als nicht lösbare Verbindungen C sind beispielsweise Löt- oder Klebeverbindungen vorsehbar.

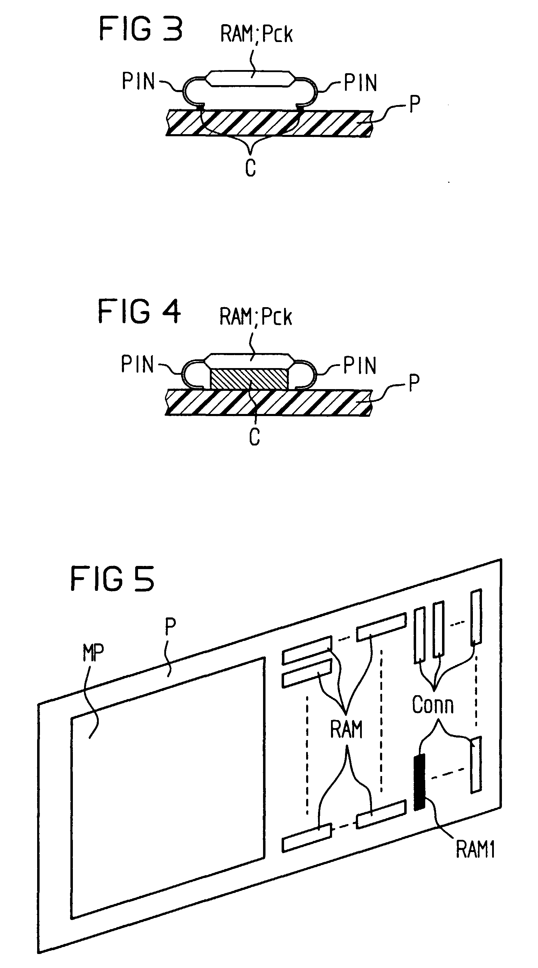

Figur 3 zeigt im Detail einen in einem Gehäuse Pck befindlichen Speicherbaustein RAM, dessen zugehörige Anschlußbeinchen PIN mit der Platine P nicht lösbar verbunden (C) ist, zum Beispiel mittels einer Lötverbindung.

Figur 4 zeigt im Detail einen in einem Gehäuse Pck befindlichen Speicherbaustein RAM, bei dem die nicht lösbare Verbindung C direkt zwischen dem Gehäuse Pck und der Platine P angeordnet ist, zum Beispiel in Form einer Klebeverbindung.

Figur 2 zeigt, analog zu Figur 1, eine Platine P mit einem Prozessorbaustein MP und Speicherbausteinen RAM, die ebenfalls nicht lösbar (C) mit der Platine P verbunden sind. Die Speicherbausteine RAM sind dabei jedoch im unterschied zu Figur 1 nicht in Gehäuse Pck vergossen, sondern sie liegen lediglich in Form von sogenannten Chips CH vor. Diese Chips CH sind direkt mit der Platine P nicht lösbar verbunden (C), zum Beispiel verklebt.

Figur 5 zeigt eine Weiterbildung der Ausgestaltungen der Platine P nach den Figuren 1 oder 2, bei der auf der Platine P zusätzlich zu den Speicherbausteinen RAM noch in bekannter Weise Sockel Conn (zum Beispiel Steck- oder Klemmsockel) angeordnet sind. Diese dienen bei Bedarf (das heißt, es ist ein größerer Arbeitsspeicher gewünscht, als sich aus der Anzahl und Speicherkapazität der erfindungsgemäß vorgesehenen Speicherbausteine RAM ergibt, der Aufnahme weiterer Speicherbausteine RAM1. Diese sind dann in den Sockeln Conn lösbar, zum Beispiel steckbar, angeordnet.

## Patentansprüche

1. Platine, insbesondere für ein Datenverarbeitungsgerät, die eine Mehrzahl von Speicherbausteinen (RAM) enthält,
**dadurch gekennzeichnet,** daß
die Speicherbausteine (RAM) als in Gehäuse (Pck) montierte oder vergossene Chips (CH) auf der Platine montiert sind, wobei eine nicht lösbare Verbindung (C) direkt zwischen dem Gehäuse (Pck) und der Platine (C) und eine lösbare Verbindung zwischen Anschlußbeinchen (PIN) der Speicherbausteine (RAM) und der Platine (C) vorgesehen sind.

2. Platine nach Anspruch 1,
**dadurch gekennzeichnet,** daß
die nicht lösbare Verbindung (C) eine Klebeverbindungen ist.

3. Platine nach Anspruch 1 oder 2,
**dadurch gekennzeichnet,** daß
die Platine (P) darüber hinaus in bekannter Weise Sockel (Conn) aufweist zur Aufnahme weiterer Speicherbausteine (RAM1).
